# EUROPÄISCHE PATENTANMELDUNG

(11) **EP 2 434 621 A2**
(43) Veröffentlichungstag der Anmeldung: **28.03.2012**
(21) Anmeldenummer: 11007252.7
(22) Anmeldetag: 07.09.2011
(51) Int. Cl.: H02K 11/00, H02K 5/22

(54) **Steuereinheit mit Spannungsquelle für eine elektromotorische Möbelantriebseinrichtung**

(30) Priorität: 24.09.2010 DE 102010046379
(71) Anmelder: ilcon GmbH, 57258 Freudenberg (DE)
(72) Erfinder: Hüppe, Michael, 51647 Gummersbach (DE); Kritzler, Michael, 51647 Gummersbach (DE)
(74) Vertreter: Polypatent

(57) **Zusammenfassung**

Die Erfindung betrifft eine Steuereinheit (1) mit Akkus für eine elektromotorische Möbelantriebseinrichtung mit wenigstens einer Antriebseinheit, die mit einem verstellbaren Bauteils eines Möbels oder einer Hubeinrichtung koppelbar ist. Die Steuereinheit (1) umfasst ein erstes mit Bedienelementen und elektronischen Bauteilen (7) versehenes Gehäuseteil (2) und ein zweites, die Akkus umfassendes Gehäuseteil (3), wobei das letztere an dem ersten Gehäuseteil (2) elektrisch leitend ansetzbar und von diesem abnehmbar ist. Zur Herstellung einer elektrisch leitenden Verbindung zwischen den Akkus (8) und den elektronischen Bauteilen ist wenigstens eine Steckverbindung vorgesehen, wobei ein wenigstens ein Stecker (11) an einem Gehäuseteil (2) vorgesehen ist, der mit einem komplementär ausgebildeten Steckaufnahme (12) an dem anderen Gehäuseteil (2,3) zusammenwirkt. Die Steuereinheit (1) zeichnet sich dadurch aus, dass der Stecker (11) so angeordnet ist, dass dieser eine elektrisch leitende Kontaktierung, etwa senkrecht zur Längserstreckung der Gehäuseteile ermöglicht.

## Beschreibung

Die Erfindung betrifft eine Steuereinheit mit Spannungsquelle für eine elektromotorische Möbelantriebseinrichtung mit wenigstens einer Antriebseinheit, die mit einem verstellbaren Bauteil eines Möbels oder einer Hubeinrichtung koppelbar ist, wobei die Steuereinheit ein erstes mit elektrischen und/oder elektronischen Bauteilen versehenes Gehäuseteil und ein zweites mit einer Spannungsquelle versehenes Gehäuseteil umfasst, das an dem ersten Gehäuseteil elektrisch leitend ansetzbar und von diesem abnehmbar ist, wobei zur Herstellung einer elektrisch leitenden Verbindung zwischen der Spannungsquelle und den elektrischen/elektronischen Bauteilen an den Gehäuseteilen jeweils elektrisch leitende Kontakte vorgesehen sind, die über wenigstens eine Steckverbindung kontaktierbar sind, wobei wenigstens ein Stecker an einem Gehäuseteil vorgesehen ist, der mit einer komplementär ausgebildeten Steckaufnahme an dem anderen Gehäuseteil zusammenwirkt.

Eine derartige Steuereinheit ist beispielsweise aus der DE 10 2008 056 982 A 1 bekannt. Die DE 10 2008 056 982 A1 betrifft eine elektromotorische Möbelantriebseinrichtung mit einem Antriebsmotor und mit einer Antriebseinheit, dessen Antriebsglied mit einem verstellbaren Bauteil eines Möbels oder einer Hubeinrichtung koppelbar ist, wobei die Möbelantriebseinrichtung ein mit einem Akku bestücktes Gehäuse umfasst, welches zur Stromversorgung an die Steuereinheit elektrisch leitend ansetzbar ist und welches zum Aufladen des Akkumulators davon abnehmbar und an ein Ladegerät anschließbar ist. Solche elektromotorischen Möbelantriebseinrichtungen werden beispielsweise für mobile Hubeinrichtungen im Krankenhausbereich und im Pflegebereich verwendet, beispielsweise für Krankenbetten, Pflegebetten, Patientenlifter und dergleichen. Dabei sollte die Steuereinheit mit gegebenenfalls daran vorgesehenen Bedienelementen ortsfest an dem Möbelstück bzw. an dem Patientenlifter angeordnet sein , ein Akkuteil sollte allerdings abnehmbar an der Steuereinheit vorgesehen sein, um das umständliche Heranfahren des Möbels an eine Ladestelle zu vermeiden.

Insbesondere bei Einsatz der Steuereinheit im Pflegebereich und im Krankenhausbereich besteht die Anforderung einer wasserdichten Kapselung der einzelnen Komponenten. Es muss sichergestellt sein, dass weder in die Möbelverstelleinrichtung noch in den das den Akkumulator aufnehmenden Gehäuse noch an stromführende Kontakte Feuchtigkeit gelangen kann.

Um eine solche Wasserdichtigkeit zu gewährleisten, wird in der DE 10 2008 056 982 A1 vorgeschlagen, an einer Stirnseite eines ersten Gehäuseteils um die elektrisch leitenden Kontakte einen gegenüber der Stirnfläche des Gehäuseteils vorstehenden Kragen vorzusehen, der eine Art Stecker bildet, welcher in eine entsprechend ausgebildete Steckaufnahme an der Stirnfläche des anzuschließenden zweiten Gehäuseteils eintaucht. Der vorstehende Kragen ist mit einem außen umlaufenden Dichtring versehen, welcher die Steckverbindung an der umlaufenden Umfassungswand der Steckaufnahme innen abdichtet. Beide Gehäuseteile sind auf einer Tragschiene angeordnet, wobei zum Ansetzen des zweiten Gehäuseteils an das erste Gehäuseteil zunächst die elektrisch leitende Verbindung zwischen den Gehäuseteilen durch Einsetzen von Stecker und Steckaufnahme hergestellt wird und sodann das Gehäuse an dem von der Steckverbindung abliegenden Ende auf der Tragschiene verrastet wird. Hierzu ist zunächst ein gekipptes Ansetzen des zweiten Gehäuseteils an das erste Gehäuseteil erforderlich, sodann wird das zweite Gehäuseteil axial in Richtung auf das erste Gehäuseteil verschoben und zwecks Verrastung mit der Tragschiene verschwenkt.

Diese Konstruktion hat in bezug auf die Wasserdichtigkeit der Anordnung gleich mehrere Nachteile. Einerseits wird die Dichtschnur der Steckverbindung durch die Schwenkverbindung und ein damit einhergehendes Verkanten des zweiten Gehäuseteils unzulässig beansprucht, d.h. Querkräften ausgesetzt, andererseits ist die Steckverbindung durch die Trennfuge zwischen dem ersten und dem zweiten Gehäuseteil zugänglich, so dass grundsätzlich Feuchtigkeit zwischen die Gehäuseteile gelangen kann. Bei dauerhafter Beanspruchung der Dichtung in der zuvor beschriebenen Art und Weise kann auf die Dauer ein Vordringen von Feuchtigkeit an die elektrischen Kontakte nicht verhindert werden.

Der Erfindung liegt daher die Aufgabe zugrunde, eine Steuereinheit der eingangs beschriebenen Art hinsichtlich der Anforderungen an die wasserdichte Kapselung zu verbessern.

Auch soll die Handhabbarkeit der Steuereinheit verbessert werden.

Die Aufgabe wird gelöst durch eine Steuereinheit der vorstehend genannten Art, die sich dadurch auszeichnet, dass der Stecker so angeordnet ist, dass dieser eine elektrisch leitende Kontaktierung etwa senkrecht zur Längserstreckung der Gehäuseteile ermöglicht.

Dies hat insbesondere den Vorzug, dass beim Ansetzen des zweiten Gehäuseteils an das erste Gehäuseteil die Steckverbindung nahezu frei von unzulässigen Querkräften gehalten wird, so dass etwa an dem Stecker oder an der Steckaufnahme vorgesehene Dichtungen nicht unzulässig mechanisch beansprucht werden. Hierdurch ist auch bei starker Beanspruchung der Steuereinheit im Sinne von häufigem Abnehmen und Ansetzen des zweiten Gehäuseteils eine dauerhafte Wasserdichtigkeit gewährleistet.

Bei einer vorteilhaften Variante der Steuereinheit gemäß der Erfindung ist vorgesehen, dass der Stecker aus einem Gehäuseteil herausgeführt ist und bei Herstellung der Verbindung in eine an der Unterseite des jeweils anderen Gehäuseteils vorgesehene Steckaufnahme derart eintaucht, dass die Steckverbindung vollständig durch das Gehäuseteil abgedeckt ist. Bei dieser zweckmäßigen und vorteilhaften Variante der Steuereinheit ist die Steckverbindung außerhalb der Trennfuge zwischen den Gehäuseteilen angeordnet, so dass etwa zwischen die Gehäuseteile gelangende Feuchtigkeit nicht an die Steckverbindung gelangen kann. Hierdurch ist insbesondere gewährleistet, dass selbst bei nicht korrektem Dichtschluss einer an der Steckverbindung vorgesehenen Dichtung, keine Feuchtigkeit an die elektrischen Kontakte gelangt.

Zweckmäßigerweise ist der Stecker als Winkelstecker ausgebildet.

Bei einer besonders bevorzugten Variante der Steuereinheit gemäß der Erfindung ist der Stecker Teil einer stirnseitigen Abdeckkappe eines Gehäuseteils. Hierdurch wird insbesondere ein hoher Integrationsgrad der verschiedenen Funktionalitäten der verwendeten Bauteile erzielt. Dies hat auch herstellungstechnische Vorteile, beispielsweise können die Abdeckkappe und der Stecker einstückig ausgebildet sein.

Besonders vorteilhaft ist es, wenn die Abdeckkappe als Zugentlastung für wenigstens eine Kabelverbindung von der Steuereinheit zu der Antriebseinheit ausgebildet ist.

Wenigstens eine Abdeckkappe umfasst wenigstens eine Steckerdurchführung für den Stecker einer Kabelverbindung von der Steuereinheit zu einem Antriebsmotor. Die Kabelverbindung dient dabei zweckmäßigerweise sowohl zur Spannungsversorgung eines oder mehrerer Antriebsmotoren als auch zu Ansteuerung dieser Motoren.

Bei einer vorteilhaften Ausführungsform der Erfindung ist die Abdeckkappe zweiteilig ausgebildet, wobei ein erstes und ein zweites Kappenteil in Einbaulage wenigstens ein Verbindungskabel zugentlastet zwischen sich festlegen. Hierbei ist besonders vorteilhaft, wenn die Zugentlastung derart ausgebildet ist, dass die Kabelverbindung in einem definierten Biegeradius gehalten wird, der bevorzugt nicht kleiner als 90° ist. Dies wird insbesondere auch dadurch gewährleistet, dass durch die Festlegung des Verbindungskabels oder der Verbindungskabel zwischen zwei Kappenteilen eine definierte Lage der Verbindungskabel im Anschlussbereich gewährleistet ist.

Es ist insbesondere vorteilhaft, wenn die betreffende Abdeckkappe, als die mit dem Stecker versehene Abdeckkappe ausgebildet ist.

Bei einer besonders bevorzugten und vorteilhaften Variante der Steuereinheit gemäß der Erfindung ist vorgesehen, dass die Gehäuseteile auf einer Tragschiene angeordnet sind, die mit wenigstens einem Gehäuseteil einen Kabelkanal für wenigstens ein Verbindungskabel bildet. Besonders bevorzugt wird der Kabelkanal zwischen dem zweiten Gehäuseteil mit der Spannungsquelle und der Tragschiene gebildet, so dass sowohl die Anschlüsse der Verbindungskabel als auch ein Teil der Verbindungskabel vollständig von den Gehäuseteilen verdeckt werden. Diese Anordnung ist nicht zuletzt aus hygienischen Gründen sehr vorteilhaft. Bekanntlich sind Kabel Schmutzfänger und schwer zu reinigen.

Bei einer vorteilhaften Variante der Steuereinheit gemäß der Erfindung ist vorgesehen, dass das erste und das zweite Gehäuseteil jeweils im Bereich einander zugewandter Stirnseiten formschlüssig miteinander verriegelbar sind. Als Mittel zur Verriegelung der Gehäuseteile miteinander kann beispielsweise an einem Gehäuseteil ein schwenkbarer Verriegelungshebel vorgesehen sein, der beispielsweise in einer Ausnehmung an der Stirnseite des anderen Gehäuseteils verlagerbar ist.

Alternativ können das erste und zweite Gehäuseteil über eine Schnapp-/Rastverbindung miteinander verrastbar sein.

Vorteilhaft ist es, wenn wenigstens eine Abdeckkappe einen Teil einer Rastverbindung zwischen den Gehäuseteilen bildet.

Wie vorstehend bereits erwähnt, ist der Stecker zweckmäßigerweise einstückig an das erste Kappenteil angeformt.

Bei einer zweckmäßigen Variante der Steuereinheit gemäß der Erfindung ist vorgesehen, dass das erste Gehäuseteil auf seiner Unterseite wenigstens eine Durchführung und/oder Steckaufnahme und/oder Stecker für eine Kabelverbindung aufweist. Zweckmäßigerweise ist das erste Gehäuseteil auf seiner der Tragschiene zugewandten Unterseite mit einer Durchführung und/oder Steckaufnahme für den Stecker einer Kabelverbindung versehen. Das Verbindungskabel wird somit nicht nur vollständig von dem Gehäuseteil verdeckt, auch wird auf diese Art und Weise eine Umlenkung des oder der Verbindungskabel vermieden, so dass die Verbindungskabel frei von Biegebeanspruchung sind.

Eine vorteilhafte Ausgestaltung der Erfindung wird nachstehend anhand zweier in den Zeichnungen dargestellter Ausführungsbeispiele erläutert. Es zeigen:
- Fig. 1: eine perspektivische Darstellung der Steuereinheit gemäß einem ersten Ausführungsbeispiel der Erfindung bei nicht vollständig angesetztem zweiten Gehäuseteil,
- Fig. 2: einen Längsschnitt durch die Steuereinheit in zusammengesetztem Zustand,
- Fig. 3: eine Explosionsansicht der Abdeckkappen der einander zugewandten Stirnseiten der Gehäuseteile,
- Fig. 4: eine der Fig. 3 entsprechende Ansicht aus einer anderen Richtung,
- Fig. 5: eine Explosionsansicht einer zweiteiligen Abdeckkappe mit zwischen den Kappenteilen angeordneten Verbindungskabeln, und
- Fig. 6: eine perspektivische Darstellung der Steuereinheit gemäß einem zweiten Ausführungsbeispiel der Erfindung,
- Fig. 7: eine weitere perspektivische Darstellung der Steuereinheit nach dem zweiten Ausführungsbeispiel der Erfindung, und
- Fig. 8: eine dritte perspektivische Darstellung der Steuereinheit nach dem zweiten Ausführungsbeispiel der Erfindung.

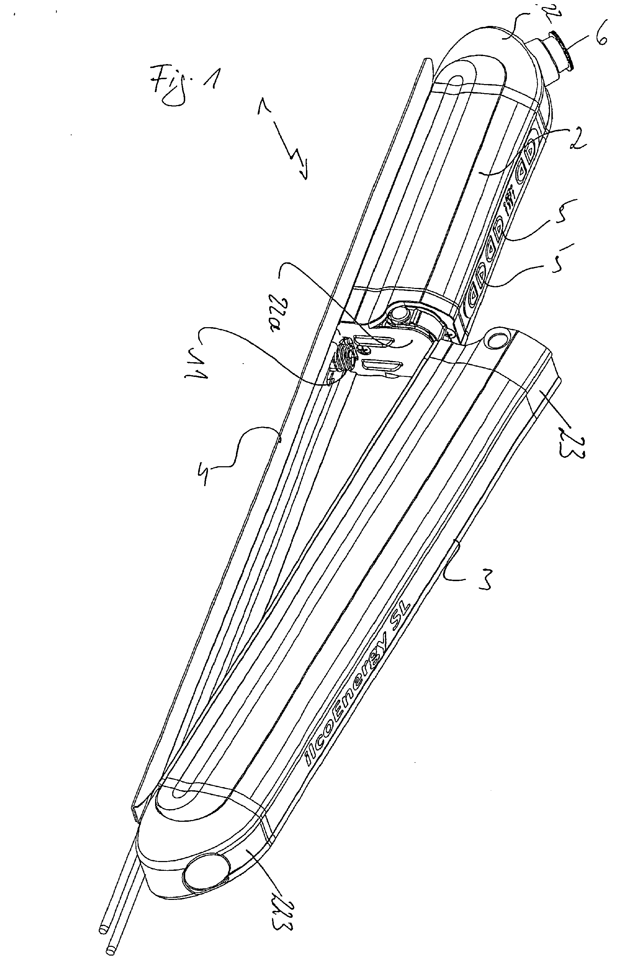

Fig. 1 zeigt die Steuereinheit 1 gemäß der Erfindung in etwa in ihrer Einbaulage an einem vertikalen Profil eines nicht dargestellten Patientenlifters. Diese umfasst ein erstes Gehäuseteil 2, ein zweites Gehäuseteil 3 sowie eine Tragschiene 4, wobei das erste Gehäuseteil 2 ortsfest an der Tragschiene 4 befestigt ist, die wiederum beispielsweise mit einer Vertikalstrebe eines Patientenlifters verschraubt ist.

Es versteht sich von selbst, dass die Steuereinheit auch an anderen Möbelteilen mit elektromotorischen Verstelleinrichtungen angeordnet sein kann.

Das zweite Gehäuseteil 3 ist lösbar an dem ersten Gehäuseteil 2 und an der Tragschiene 4 ansetzbar.

Das erste Gehäuseteil 2 umfasst Bedienelemente, beispielsweise in Form bekannter Folientaster 5 und einen in Einbaulage oberen Notaus-Knopf 6. Das erste Gehäuseteil 2 beinhaltet nur andeutungsweise dargestellte elektronische Bauteile 7, die jeweils der Steuerung einer elektromotorischen Antriebseinrichtung dienen. Das zweite Gehäuseteil 3 umfasst im vorliegenden Fall mehrere Akkumulatoren 8, welche nachstehend der Einfachheit halber als Akkus bezeichnet werden. Die Akkus 8 dienen zur Spannungsversorgung sowohl der elektronischen Bauteile 7 als auch der elektromotorischen Antriebseinrichtung, die nicht dargestellt ist.

Das zweite Gehäuseteil 3 ist, wie vorstehend erwähnt, abnehmbar an das erste Gehäuseteil 2 ansetzbar und zwar derart, dass die elektronischen Bauteile 7 mit den in dem zweiten Gehäuseteil 3 angeordneten Akkus elektronisch kontaktierbar sind.

Sowohl das erste als auch das zweite Gehäuseteil 2,3 sind als Aluminiumstrangpressprofile ausgebildet, die jeweils mit nachstehend noch näher zu beschreibenden Abdeckkappen 22,23,222,223 endseitig verschlossen sind.

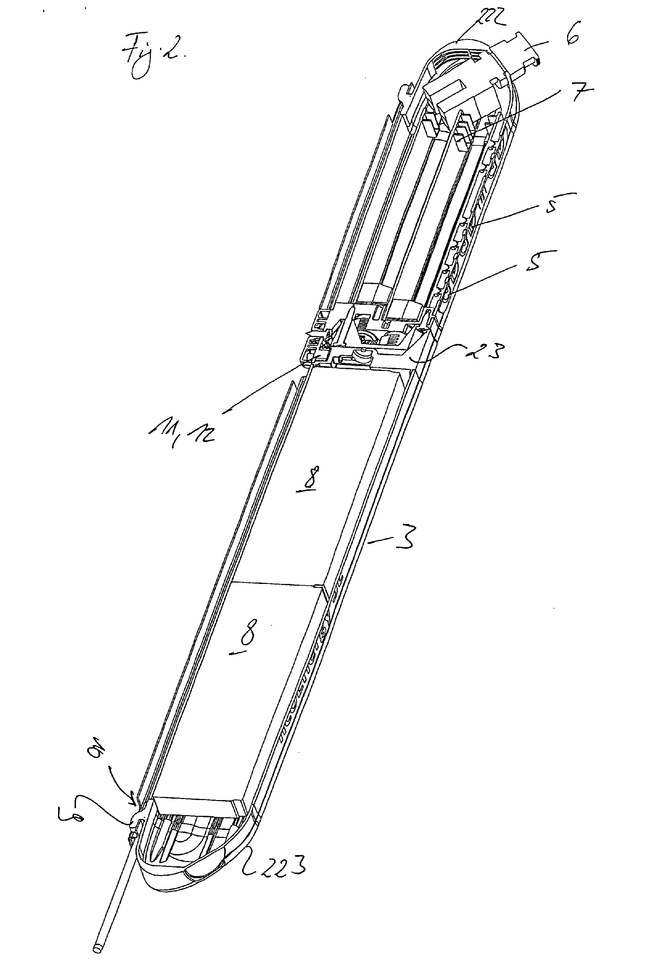

Wie dies andeutungsweise einer Zusammenschau der Figuren 1 und 2 zu entnehmen ist, wird das zweite Gehäuseteil 3 an einer Seite mit einem angeformten Haken 9 in einer fensterartigen Durchbruch 10 in der Tragschiene 4 so eingesetzt, dass der Haken 9 die Tragschiene 4 hintergreift. Sodann wird das zweite Gehäuseteil 3 in die in Fig. 2 dargestellte Endlage verschwenkt und mit dem ersten Gehäuseteil 2 verrastet, wobei gleichzeitig eine elektrische Kontaktierung zwischen den Akkus 8 und den elektronischen Bauteilen hergestellt wird, wie nachstehend noch beschrieben wird.

Hierzu ist an dem ersten Gehäuseteil 2 ein als Winkelstecker ausgebildeter Stecker 11 vorgesehen, der mit einer Steckaufnahme 12 an der Unterseite des zweiten Gehäuseteils 3 zusammenwirkt. Der Winkelstecker 11 und die Steckaufnahme 12 sind jeweils an Abdeckkappen 22 und 23 des ersten Gehäuseteils 2 und des zweiten Gehäuseteils 3 vorgesehen.

Mit 22, 23 sind die jeweils einander zugewandten Abdeckkappen im Bereich der Verbindung des ersten Gehäuseteils 2 mit dem zweiten Gehäuseteil 3 bezeichnet, wobei die Abdeckkappe 22 dem ersten Gehäuseteil und die Abdeckkappe 23 dem zweiten Gehäuseteil 3 zugeordnet ist. Die Abdeckkappen 22, 23 sind aus thermoplastischem Kunststoff ausgebildet. Die jeweils von den Abdeckkappen 22, 23 abliegenden Abdeckkappen 222, 223 bestehen ebenfalls aus thermoplastischem Kunststoff.

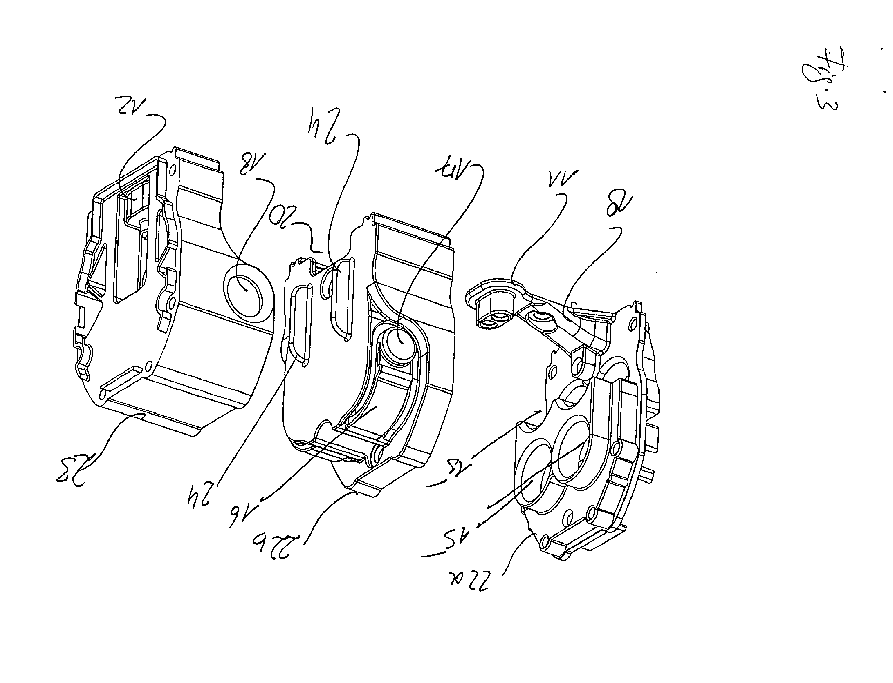

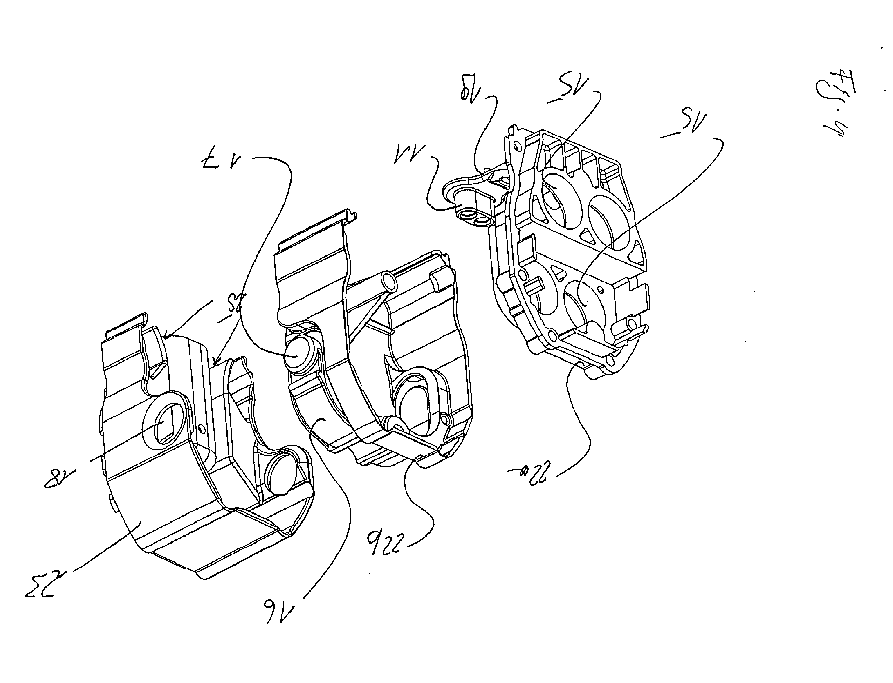

Im folgenden wird Bezug genommen auf die Figuren 3 und 4, in denen die Abdeckkappen 22, 23 in Form einer Explosionsansicht dargestellt sind. Die Abdeckkappe 22 umfasst ein erstes Kappenteil 22a und ein zweites Kappenteil 22b, welche in montierter Lage insgesamt vier Verbindungskabel 13 mit Steckern 14 zwischen sich festlegen. Die Verbindungskabel 13 dienen der Spannungsversorgung sowie der Steuerung der von der Steuereinheit anzusteuernden elektromotorischen Antriebseinrichtungen. Die Stecker 14 wirken mit Steckaufnahmen innerhalb des ersten Gehäuseteils 2 zusammen.

In der Abdeckkappe 22a des ersten Gehäuseteils sind insgesamt vier Durchführungen 15 für die Stecker 14 vorgesehen. Die elektrische Kontaktierung zwischen den Akkus 8 und den elektronischen Bauteilen 7 erfolgt über den als Winkelstecker ausgebildeten Stecker 11 und die Steckaufnahme 12, die jeweils elektrisch leitende, nicht dargestellte Kontakte aufnehmen und führen. Der Stecker 11 ist so ausgebildet, dass dessen Steckkontakte quer zur Längserstreckung der Gehäuseteile 2, 3 aus dem ersten Gehäuseteil 2 herausgeführt sind, die Steckaufnahme 12 befindet sich an der Unterseite des zweiten Gehäuseteils, präzise ausgedrückt an der Unterseite der Abdeckkappe 23, die das zweite Gehäuseteil 3 verschließt.

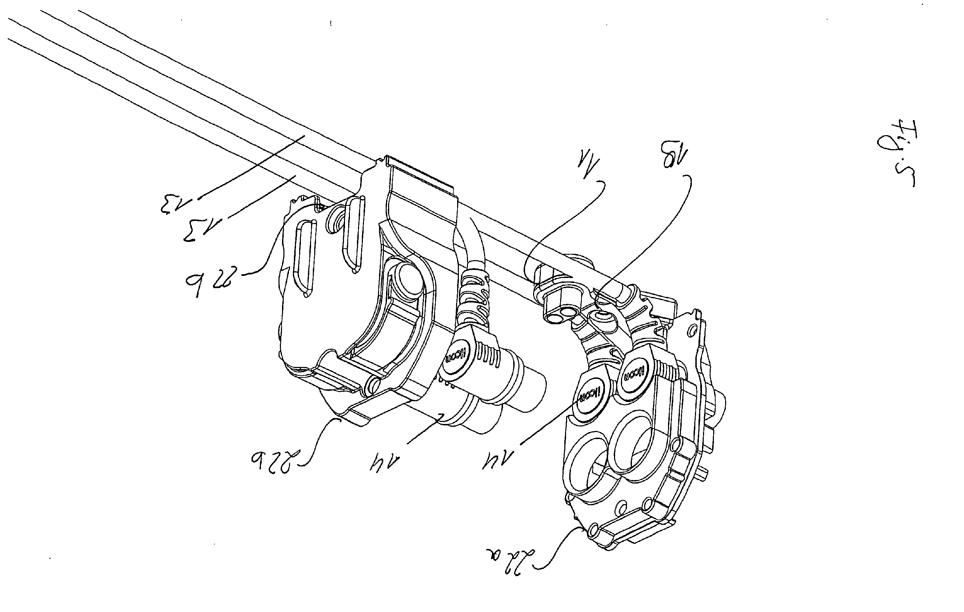

Das erste Kappenteil 22a der Abdeckkappe 22 ist in dichtender Art und Weise mit dem ersten Gehäuseteil 2 verschraubt, d.h. unter Zwischenlage einer Dichtschnur oder eines anderen Dichtmittels. Das zweite Kappenteil 22b ist wiederum mit dem ersten Kappenteil 22a verschraubbar, wobei die Kappenteile 22a und 22b die Verbindungskabel 13 in einer definierten Lage zwischen sich festlegen, und zwar derart, wie es in Fig. 5 dargestellt ist, wobei die Verbindungskabel 13 dort in einem Bogen geführt sind, dessen Krümmungsradius verhältnismäßig groß ist, so dass der Umlenkwinkel der Verbindungswinkel 13 jedenfalls größer oder gleich 90° ist.

An das zweite Kappenteil 22b sind zwei Federzungen 16 angeformt, an deren freien Enden jeweils Rastknöpfe 17 ausgebildet sind, welche mit Rastöffnungen 18 an der Abdeckkappe 23 zusammenwirken. Nach Einführen der Stecker 14 in die hierzu vorgesehenen Steckaufnahmen werden die Kappenteile 22a und 22b miteinander verschraubt. Dabei durchsetzt ein Befestigungsarm 19 des Steckers 11 einen Durchbruch 20 des zweiten Kappenteils 22b, so dass bei abgenommenem zweiten Gehäuseteil 3 der Stecker 11 freiliegt. Wird das zweite Gehäuseteil 3 in seine in Fig. 2 dargestellte Endlage verschwenkt, taucht der Stecker 11 in die Steckaufnahme 12 an der Unterseite der Abdeckkappe 23 vorgesehene Steckaufnahme 12 ein. Der Stecker 11 umfasst weiterhin einen nur aus Fig. 1 ersichtlichen Dichtungsbalg 21, der diesen in der Steckaufnahme 12 abdichtet.

Bei elektrischer Kontaktierung der elektronischen Bauteile 7 mit den Akkus 8 wird gleichzeitig eine Rastverbindung zwischen den Abdeckkappen und 22 hergestellt, indem die Rastknöpfe 17 in die zugehörigen Rastöffnungen 18 einschnappen.

Damit ein Verkanten von Stecker 11 und Steckaufnahme 12 beim Ansetzen bzw. Einsetzen des zweiten Gehäuseteils 3 zuverlässig verhindert wird, sind an dem zweiten Kappenteil 22b Führungsnasen 24 vorgesehen, die in entsprechende Nuten 25 der Abdeckkappe 23 geführt werden.

Die Abdeckkappe 23 ist mit dem zweiten Gehäuseteil 3 fest, d.h. dichtend verschraubt.

Wie insbesondere aus Fig. 1 ersichtlich ist, bilden die Tragschiene 4 und das zweite Gehäuseteil 3 einen Kabelkanal für die Verbindungskabel 13.

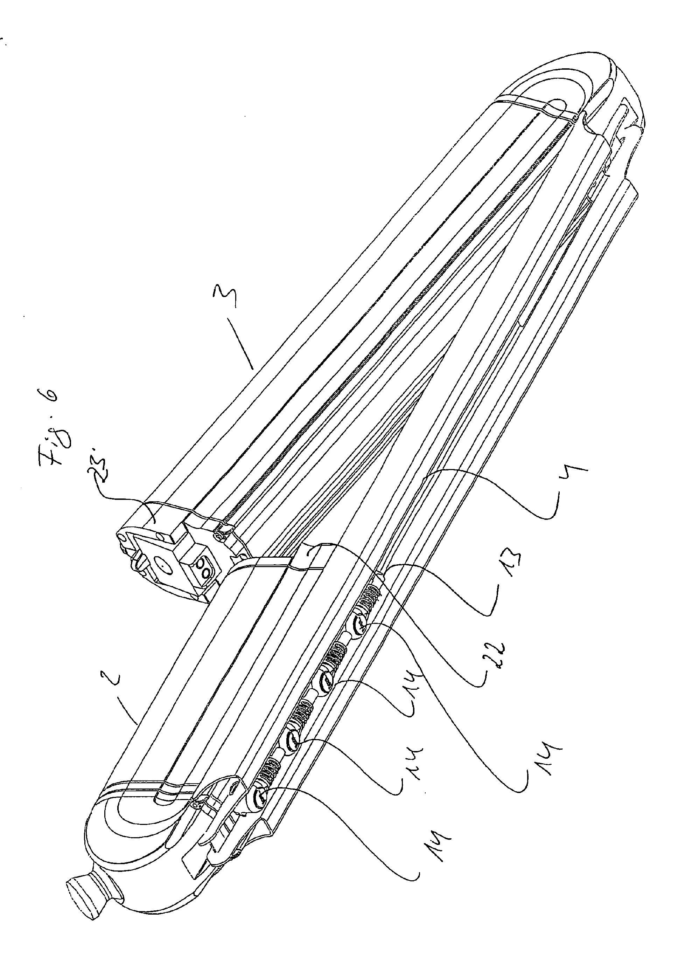

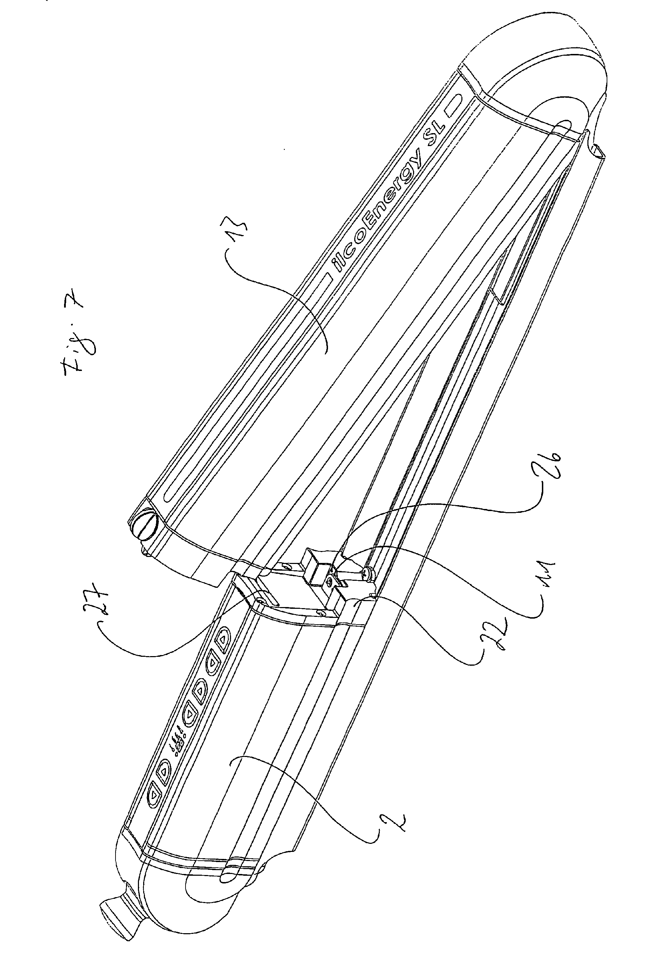

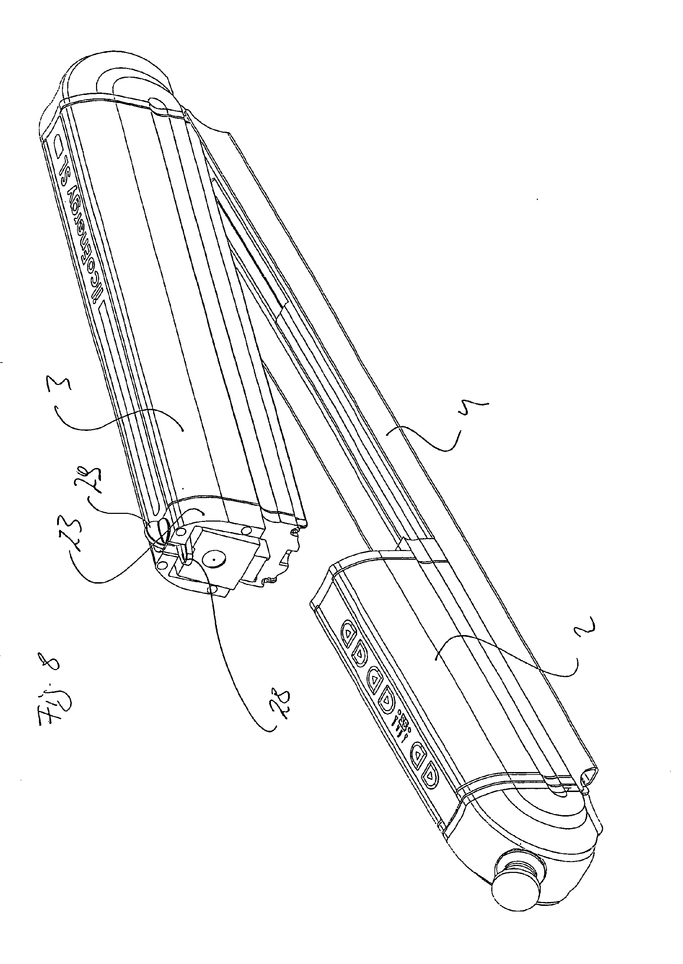

Bei dem in Figuren 6 bis 8 dargestellten zweiten Ausführungsbeispiel der Steuereinheit 1 gemäß der Erfindung sind sowohl das erste Gehäuseteil 2 als auch das zweite Gehäuseteil 3 mit einer einteiligen Abdeckkappe 22, 23 versehen. Wie insbesondere der Figur 7 zu entnehmen ist, ist die Abdeckkappe 22 nicht mit Durchführungen versehen, vielmehr sind nicht näher bezeichnete Durchführungen an der der Tragschiene 4 zugekehrten Unterseite des ersten Gehäuseteils 2 vorgesehen, und zwar insgesamt vier Stück, die jeweils die Stecker 14 der Verbindungskabel 13 aufnehmen. Wie bei dem ersten Ausführungsbeispiel der Steuereinheit 1 gemäß der Erfindung sind die Verbindungskabel 13 vollständig verdeckt von dem ersten und zweiten Gehäuseteil 2, 3 angeordnet. Die Stecker 14 sind jeweils als Winkelstecker ausgebildet und an der der Tragschiene 4 zugewandten Seite des ersten Gehäuseteils 2 an dieses angeschlossen, so dass eine Umlenkung bzw. Biegebeanspruchung der Verbindungskabel 13 nicht vorgesehen ist.

Die Abdeckkappe 22 ist nur einteilig ausgebildet. Der Stecker 11 ist in einen Absatz 26 der Abdeckkappe 22 integriert.

Die Abdeckkappe 22 ist darüber hinaus mit einer Verriegelungsnut 27 versehen, welche auf der der Abdeckkappe 23 zugewandten Stirnseite geöffnet ist. In die Abdeckkappe 23 ist Schwenkriegel 28 integriert, welcher mit einem Betätigungsknopf 29 um dessen Drehachse schwenkbar aus der Stirnfläche der Abdeckkappe 23 ein- und ausschwenkbar ist, so dass diese bei zusammengesetztem ersten und zweiten Gehäuseteil 2, 3 in verriegelter Stellung in die Verriegelungsnut 27 der Abdeckkappe 22 eintaucht.

### Bezugszeichenliste

- 1: Steuereinheit
- 2: erstes Gehäuseteil
- 3: zweites Gehäuseteil
- 4: Tragschiene
- 5: Folientaster
- 6: Notaus-Knopf
- 7: Elektronische Bauteile
- 8: Akkumulatoren
- 9: Haken
- 10: Durchbruch
- 11: Stecker
- 12: Steckaufnahme
- 13: Verbindungskabel
- 14: Stecker
- 15: Durchführungen
- 16: Federzungen
- 17: Rastknöpfe
- 18: Rastöffnungen
- 19: Befestigungsarm
- 20: Durchbruch
- 21: Dichtungsbalg
- 22: Abdeckkappe
- 22a: erstes Kappenteil
- 22b: zweites Kappenteil
- 23: Abdeckkappe
- 222,223: Abdeckkappen
- 24: Führungsnasen
- 25: Nuten
- 26: Absatz
- 27: Verriegelungsnut
- 28: Schwenkriegel
- 29: Betätigungsknopf

## Patentansprüche

1. Steuereinheit (1) mit Spannungsquelle für eine elektromotorische Möbelantriebseinrichtung mit wenigstens einer Antriebseinheit, die mit einem verstellbaren Bauteil eines Möbels oder einer Hubeinrichtung koppelbar ist, wobei die Steuereinheit (1) ein erstes elektrische und/oder elektronische Bauteile (7) umfassendes Gehäuseteil (2) und wenigstens ein zweites mit einer Spannungsquelle versehenes Gehäuseteil (3) umfasst, das an dem ersten Gehäuseteil (2) elektrisch leitend ansetzbar und von diesem abnehmbar ist, wobei zur Herstellung einer elektrisch leitenden Verbindung zwischen der Spannungsquelle und dem elektrischen/elektronischen Bauteilen (7) an den Gehäuseteilen (2,3) jeweils elektrisch leitende Kontakte vorgesehen sind, die über wenigstens eine Steckverbindung kontaktierbar sind, wobei wenigstens ein Stecker (11) an einem Gehäuseteil (2,3) vorgesehen ist, der mit einer komplementär ausgebildeten Aufnahme (12) an dem anderen Gehäuseteil (2,3) zusammenwirkt, **dadurch gekennzeichnet, dass** der Stecker (11) so angeordnet ist, dass dieser eine elektrisch leitende Kontaktierung etwa senkrecht zur Längserstreckung der Gehäuseteile (2,3) ermöglicht.

2. Steuereinheit nach Anspruch 1, **dadurch gekennzeichnet, dass** der Stecker (11) aus einem Gehäuseteil (2,3) herausgeführt ist und bei Herstellung der Verbindung in eine an der Unterseite des jeweils anderen Gehäuseteils (2,3) vorgesehene Steckaufnahme (12) eintaucht, derart, dass die Steckverbindung vollständig durch das Gehäuseteil (2,3) abgedeckt ist.

3. Steuereinheit nach einem der Ansprüche 1 oder 2, **dadurch gekennzeichnet, dass** der Stecker (11) als Winkelstecker ausgebildet ist.

4. Steuereinheit nach einem der Ansprüche 1 bis 3, **dadurch gekennzeichnet, dass** der Stecker (11) Teil einer stirnseitigen Abdeckkappe (22,23) eines Gehäuseteils (2,3) ausgebildet ist.

5. Steuereinheit nach einem der Ansprüche 1 bis 4, **dadurch gekennzeichnet, dass** die Abdeckkappe (22,23) als Zugentlastung wenigstens für eine Kabelverbindung von der Steuereinheit (1) zu einer Antriebseinheit ausgebildet ist.

6. Steuereinheit nach einem der Ansprüche 4 oder 5, **dadurch gekennzeichnet, dass** die Abdeckkappe (22,23) wenigstens eine Durchführung (15) für den Stecker (14) wenigstens einer Kabelverbindung aufweist.

7. Steuereinheit nach einem der Ansprüche 1 bis 6, **dadurch gekennzeichnet, dass** die Abdeckkappe (22a,22b) zweiteilig ausgebildet ist, wobei ein erstes und ein zweites Kappenteil (22a,22b) wenigstens ein Verbindungskabel (13) zugentlastet zwischen sich festlegen.

8. Steuereinheit nach einem der Ansprüche 1 bis 7, **dadurch gekennzeichnet, dass** die Gehäuseteile (2,3) auf einer Tragschiene (4) angeordnet sind, welche mit wenigstens einem Gehäuseteil (2,3) einen Kabelkanal für wenigstens ein Verbindungskabel (13) bildet.

9. Steuereinheit nach einem der Ansprüche 1 bis 8, **dadurch gekennzeichnet, dass** das erste und das zweite Gehäuseteil (2,3) jeweils im Bereich einander zugewandter Stirnseiten formschlüssig miteinander verriegelbar sind.

10. Steuereinheit nach einem der Ansprüche 1 bis 9, **dadurch gekennzeichnet, dass** das erste und das zweite Gehäuseteil (2, 3) jeweils im Bereich einander zugewandter Stirnseiten formschlüssig miteinander verrastbar sind.

11. Steuereinheit nach einem der Ansprüche 4 bis 10, **dadurch gekennzeichnet, dass** wenigstens eine Abdeckkappe (22,23) einen Teil einer Rastverbindung zwischen den Gehäuseteilen (2,3) bildet.

12. Steuereinheit nach einem der Ansprüche 7 bis 11, **dadurch gekennzeichnet, dass** der Stecker (11) einstückig an das erste Kappenteil (22a) angeformt ist.

13. Steuereinheit nach Anspruch 8, **dadurch gekennzeichnet, dass** das erste Gehäuseteil (2) auf seiner der Tragschiene (4) zugewandten Unterseite wenigstens eine Durchführung und/oder Steckaufnahme für den Stecker (14) einer Kabelverbindung (13) aufweist.
